# DEMANDE DE BREVET EUROPEEN

(11) **EP 4 823 275 A1**
(43) Date de publication de la demande: **14.10.2026**
(21) Numéro de dépôt: 26169538.1
(22) Date de dépôt: 31.03.2026
(51) Int. Cl.: H10D 62/10, H10D 89/60

(54) **DISPOSITIF DE PROTECTION CONTRE LES DECHARGES ELECTROSTATIQUES**

(30) Priorité: 09.04.2025 FR 2503753
(71) Demandeur: STMicroelectronics International N.V., 1228 Plan-les-Ouates, Geneva (CH)
(72) Inventeur: ARNAUD, Aurelie, 37540 Saint-Cyr-sur-Loire (FR); SAVARI MUTHU, Irene Monica Lasar, 560134 Singapour (SG)
(74) Mandataire: Cabinet Beaumont

(57) **Abrégé**

La présente description concerne un dispositif de protection contre les décharges électrostatiques (200) comprenant successivement :
- un substrat semiconducteur (101) dopé du type P ;
- une première couche semiconductrice (103) dopée du type N, sur et en contact avec une face supérieure du substrat ;
- une deuxième couche semiconductrice (115) dopée d'atomes de bore, sur et en contact avec la première couche, la deuxième couche ayant une concentration en atomes de bore supérieure ou égale à 10¹⁷ atomes/cm³ ; et
- une troisième couche semiconductrice dopée du type N, sur une face supérieure de la deuxième couche, la première couche étant plus fortement dopée que la troisième couche,

le dispositif comportant en outre des tranchées d'isolation (107) s'étendant à travers les première, deuxième et troisième couches et débouchant dans le substrat, définissant, dans la troisième couche, entre les tranchées, au moins un caisson.

## Description

### Domaine technique

La présente description concerne de façon générale les dispositifs électroniques et plus particulièrement, les dispositifs électroniques de protection contre des décharges électrostatiques ou ESD (de l'anglais « Electrostatic Discharge »).

### Technique antérieure

On connait différents dispositifs de prévention et de protection contre des décharges électrostatiques.

Il serait souhaitable de pallier au moins en partie à certains inconvénients des réalisations connues de tels dispositifs.

### Résumé de l'invention

Pour cela, un mode de réalisation prévoit un dispositif de protection contre les décharges électrostatiques comprenant successivement :
- un substrat semiconducteur dopé du type P ;
- une première couche semiconductrice dopée du type N, sur et en contact avec une face supérieure du substrat semiconducteur;
- une deuxième couche semiconductrice dopée d'atomes de bore, sur et en contact avec la première couche semiconductrice, la deuxième couche semiconductrice ayant une concentration en atomes de bore supérieure ou égale à 1017 atomes/cm3 ; et
- une troisième couche semiconductrice dopée du type N, sur une face supérieure de la deuxième couche semiconductrice, la première couche semiconductrice étant plus fortement dopée que la troisième couche semiconductrice ,
le dispositif comportant en outre des tranchées d'isolation s'étendant à travers les première, deuxième et troisième couches semiconductrices et débouchant dans le substrat semiconducteur, définissant, dans la troisième couche semiconductrice, entre les tranchées d'isolation, au moins un caisson.

Selon un mode de réalisation, la deuxième couche semiconductrice a une épaisseur comprise dans la plage allant de 3 µm à 5 µm.

Selon un mode de réalisation, les tranchées d'isolation sont remplies d'un matériau isolant.

Selon un mode de réalisation, la deuxième couche semiconductrice a une concentration en bore comprise dans la plage allant de 10¹⁷ atomes/cm³ à 10¹⁹ atomes/cm³.

Selon un mode de réalisation, la première couche semiconductrice a une concentration en éléments dopants de type N comprise dans la plage allant de 10¹⁶ atomes/cm³ à 10¹⁸ atomes/cm³.

Selon un mode de réalisation, la première couche semiconductrice a une épaisseur comprise dans la plage allant de 1 µm à 5 µm.

Selon un mode de réalisation, ledit au moins un caisson a une largeur comprise dans la plage allant de 50 µm à 150 µm.

Selon un mode de réalisation, ledit au moins un caisson comprend une diode.

Selon un mode de réalisation, les tranchées d'isolation définissent dans la troisième couche plusieurs caissons successifs comprenant chacun une diode, les diodes desdits caissons successifs étant connectées en série.

Selon un mode de réalisation, les première et deuxième couches s'étendent chacune de façon continue sur sensiblement toute la surface du substrat et sont interrompues uniquement par les tranchées d'isolation.

Selon un mode de réalisation, les première et deuxième couches sont interrompues entre deux tranchées d'isolation voisines.

Un autre mode de réalisation prévoit un procédé de fabrication d'un dispositif de protection contre les décharges électrostatiques comprenant les étapes suivantes successives :
a) former une première couche semiconductrice dopée du type N, sur et en contact avec une face supérieure d'un substrat semiconducteur dopé du type P;
b) former une deuxième couche semiconductrice dopée d'atomes de bore, sur et en contact avec la première couche semiconductrice, la deuxième couche semiconductrice ayant une concentration en atomes de bore supérieure ou égale à 1017 atomes/cm3 ;
c) former une troisième couche semiconductrice dopée du type N, sur une face supérieure de la deuxième couche semiconductrice, la première couche semiconductrice étant plus fortement dopée que la troisième couche semiconductrice ; et
d) former deux tranchées d'isolation s'étendant à travers les première, deuxième et troisième couches semiconductrices et débouchant dans le substrat semiconducteur, définissant, dans la troisième couche semiconductrice, entre les tranchées d'isolation, un caisson.

Selon un mode de réalisation, la première couche est formée par épitaxie à partir de la face supérieure du substrat et la deuxième couche est formée par implantation d'atomes de bore à partir de la face supérieure de la première couche.

Selon un mode de réalisation, la première couche et la deuxième couche sont formées respectivement par implantation d'éléments dopants de type N et par implantation d'atomes de bore à partir de la face supérieure du substrat semiconducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues partielles et schématiques d'exemples de dispositifs électroniques de protection contre des décharges électrostatiques ;
la figure 2 est une vue partielle et schématique d'un exemple d'un dispositif électronique de protection contre des décharges électrostatiques selon un premier mode de réalisation ;
la figure 3 est une vue partielle et schématique d'un exemple d'un dispositif électronique de protection contre des décharges électrostatiques selon un deuxième mode de réalisation ;
la figure 4A, la figure 4B, le figure 4C et la figure 4D sont des vues partielles et schématiques d'étapes successives d'un exemple d'un procédé de fabrication du dispositif électronique illustré en figure 3 ; et
la figure 5 est un schéma électrique du circuit de protection contre des décharges électrostatiques du dispositif électronique illustré en figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

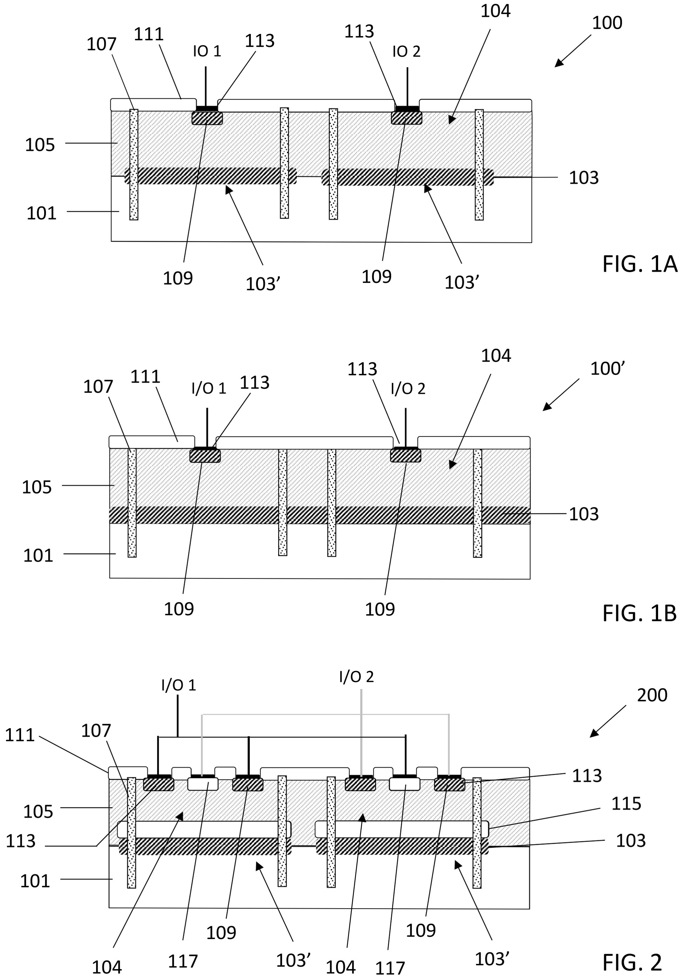

La figure 1A et la figure 1B sont des vues partielles et schématiques d'exemples de dispositifs électroniques de protection contre des décharges électrostatiques. Plus particulièrement, la figure 1A illustre un dispositif électronique 100 et la figure 1B illustre un dispositif électronique 100'.

Le dispositif 100 comprend un substrat semiconducteur 101 dopé du type P. A titre d'exemple, le substrat 101 est dopé en atomes de bore. A titre d'exemple, le substrat semiconducteur 101 est en un matériau de forte résistivité, par exemple de résistivité supérieure à 80 Ω.cm. A titre d'exemple, le substrat 101 a une concentration en éléments dopants comprise dans la plage allant de 10¹³ atomes/cm³ à 10¹⁵ atomes/cm³, par exemple de l'ordre de 10¹⁴ atomes/cm³.

Le dispositif 100 comprend une couche semiconductrice 103, disposée dans et sur le substrat 101 et par exemple en contact avec la face supérieure du substrat 101. A titre d'exemple, dans le dispositif 100, la couche 103 s'étend sur le substrat 101 au-delà de la face supérieure du substrat 101. Dans le dispositif 100, la couche 103 ne s'étend pas sur l'entièreté de la face supérieure du substrat 101. Plus particulièrement, en figure 1A, la couche 103 comprend une pluralité de portions 103' s'étendant à la surface du substrat 101. A titre d'exemple, les portions 103' de la couche 103 sont, en figure 1A, dissociées les unes des autres. La couche 103 est dopée du type N. A titre d'exemple, la couche 103 est dopée d'atomes de phosphore ou d'arsenic. La couche 103 a par exemple une concentration en éléments dopants comprise dans la plage allant de 10¹⁶ atomes/cm³ à 10¹⁸ atomes/cm³, par exemple de l'ordre de 10¹⁷ atomes/cm³. La couche 103 a par exemple une épaisseur comprise dans la plage allant de 1 µm à 5 µm. A titre d'exemple, la couche 103 a une épaisseur de l'ordre de 2 µm lorsqu'elle est dopée en atomes d'arsenic. A titre d'exemple, la couche 103 a une épaisseur de l'ordre de 4 µm lorsqu'elle est dopée en atomes de phosphore.

Le dispositif 100 comprend une autre couche semiconductrice 105, disposée sur la face supérieure de la couche 103 et par exemple en contact avec la couche 103. A titre d'exemple, la couche 105 s'étend entre les portions 103' de la couche 103 et y est, par exemple, en contact avec le substrat 101. La couche 105 est dopée du type N. La couche 103 est plus fortement dopée que la couche 105. La couche 105 a par exemple une concentration en éléments dopants comprise dans la plage allant de 10¹³ atomes/cm³ à 10¹⁵ atomes/cm³, par exemple de l'ordre de 6.10¹³ atomes/cm³. A titre d'exemple, la couche 105 a une épaisseur comprise dans la plage allant de 10 µm à 14 µm, par exemple de l'ordre de 12 µm.

Le dispositif comporte des tranchées d'isolation 107 s'étendant à travers la couche semiconductrice 105 et la couche semiconductrice 103 et débouchant dans le substrat 101. Les tranchées 107 ont pour fonction d'isoler électriquement les uns des autres différents composants du dispositif de protection.

A titre d'exemple, les tranchées 107 s'étendent plus profondément que la face supérieure du substrat 101. A titre d'exemple, en figure 1A, chaque portion 103' de la couche 103 est traversée par deux tranchées 107. Les tranchées délimitent ainsi, dans la couche 105, des caissons 104. A titre d'exemple, chaque caisson 104 est ainsi délimité par sa face inférieure, par la couche 103. En outre, chaque caisson 104 est délimité, par ses flancs, par les tranchées 107. A titre d'exemple, chaque caisson 104 accueille un composant électronique.

A titre d'exemple, les tranchées 107 sont remplies d'un matériau isolant électrique. A titre d'exemple, les tranchées 107 sont remplies d'un oxyde, par exemple un oxyde de silicium, un oxyde thermique, du verre de silicate non dopé (USG, de l'anglais « Undoped Silicate Glass ») ou de l'orthosilicate de tétraéthyle (TEOS, de l'anglais « TetraEthylOrthoSilicate »).

A titre d'exemple, chaque caisson 104 à une largeur comprise dans la plage allant de 50 µm à 150 µm, par exemple comprise dans la plage allant de 80 µm à 120 µm, par exemple de l'ordre de 100 µm.

A titre d'exemple, chaque portion 103' de la couche 103 a une largeur supérieure à la largeur d'un caisson 104. Ainsi, chaque portion 103' s'étend par exemple au-delà du vis-à-vis du caisson 104, de part et d'autre du caisson 104. Chaque portion 103' s'étend par exemple latéralement au-delà des deux tranchées 107 qui la traversent.

A titre d'exemple, le dispositif 100 comprend une région 109 formée dans la couche 105. La région 109 affleure par exemple la face supérieure de la couche 105. La région 109 est par exemple dopée du type N. A titre d'exemple, la région 109 est plus fortement dopée que la couche 105. La région 109 a par exemple une concentration en éléments dopants comprise dans la plage allant de 10¹⁸ atomes/cm³ à 10²⁰ atomes/cm³, par exemple de l'ordre de 10¹⁹ atomes/cm³.A titre d'exemple, la région 109 s'étend, à partir de la face supérieure de la couche 105, dans la couche 105 sur une profondeur comprise dans la plage allant de 1 µm à 5 µm.

A titre d'exemple, une couche isolante 111 recouvre la face supérieure de la couche 105. A titre d'exemple, la couche 111 recouvre l'entièreté de la couche 105 sans recouvrir les régions 109. En d'autres termes, la couche 111 recouvre l'entièreté de la face supérieure de la couche 105 en étant ouverte en vis-à-vis des régions 109. La couche 111 est par exemple en un matériau isolant électrique.

A titre d'exemple, la couche 111 est en un oxyde, par exemple en un oxyde de silicium, en un oxyde thermique, en verre de silicate non dopé (USG, de l'anglais « Undoped Silicate Glass ») ou en orthosilicate de tétraéthyle (TEOS, de l'anglais « TetraEthylOrthoSilicate »).

A titre d'exemple, chaque région 109 est recouverte par et en contact avec une métallisation de contact 113. Chaque métallisation de contact est par exemple connectée à une borne I/O d'un circuit à protéger contre les décharges électrostatiques. Une région 109 est ainsi par exemple connectée à une borne IO1. Une autre région 109 voisine est par exemple connectée à une borne IO2.

Le dispositif 100' illustré en figure 1B est identique au dispositif 100 illustrée en figure 1A à la différence près que, dans le dispositif 100', la couche semiconductrice 103 s'étend sur l'entièreté de la surface du dispositif 100'. Plus précisément, dans cet exemple, la couche 103 s'étend sur l'entièreté de la face supérieure du substrat 101. Dans cet exemple, la couche 103 s'étend alors sous une pluralité de caissons 104.

Dans cet exemple, la couche 105 recouvre l'entièreté de la face supérieure de la couche 103 et est par exemple en contact avec la couche 103. Ainsi, la couche 105 n'est, dans cet exemple, pas en contact avec le substrat 101.

Les inventeurs ont constaté que, dans des structures du type décrit en relation avec les figures 1A et 1B, des charges électriques positives piégées à l'interface entre l'oxyde des tranchées 107 et le silicium entrainent une accumulation de charges négatives, dans le substrat 101, sous la couche 103, à l'interface entre les tranchées 107 et le silicium, venant compenser les charges positives du substrat 101. Les charges négatives cumulées le long des tranchées 107 sous la couche 103 peuvent provoquer la création d'un canal de conduction dans le substrat 101, dégradant les performances électriques du dispositif.

La figure 2 est une vue partielle et schématique d'un exemple d'un dispositif électronique de protection contre les décharges électrostatiques 200 selon un premier mode de réalisation.

Le dispositif 200 illustré en figure 2 est par exemple similaire au dispositif 100 illustré en figure 1A à la différence près que le dispositif 200 comprend une couche de silicium dopée au bore 115 sur et en contact avec la couche 103. Dans ce mode de réalisation, la couche 115 est en contact, par sa face inférieure, avec la face supérieure de la couche 103. Dans ce mode de réalisation, la couche 115 est en contact, par sa face supérieure, avec la face inférieure de la couche 105. A titre d'exemple, dans ce mode de réalisation, la couche 115 s'étend sur l'entièreté des portions de la couche 103. A titre d'exemple, dans ce mode de réalisation, la couche 115 s'étend uniquement en vis-à-vis des portions 103' de la couche 103.

La couche 115 présente une concentration en atomes de bore supérieure ou égale à 10¹⁷ atomes/cm³, par exemple comprise dans la plage allant de 10¹⁷ atomes/cm³ à 10¹⁹ atomes/cm³, par exemple de l'ordre de 2.10¹⁸ atomes/cm³. Dans ce mode de réalisation, la couche 115 a par exemple une épaisseur comprise dans la plage allant de 3 µm à 5 µm, par exemple de l'ordre de 4 µm.

Dans l'exemple représenté en figure 2, le dispositif 200 comprend deux régions 109. A titre d'exemple, le dispositif 200 comprend de plus une région 117 formée dans la couche 105. La région 117 affleure par exemple la face supérieure de la couche 105. Les régions 109 sont par exemple formées de part et d'autre de la région 117. En outre, comme la région 109, la région 117 est surmontée par une métallisation de contact 113. La métallisation de contact 113 est par exemple en contact avec la région 117. A titre d'exemple, la région 117 est dopée du type P. La région 117 a par exemple un niveau de dopage compris dans la plage allant de 10¹⁸ atomes/cm³ à 10²⁰ atomes/cm³, par exemple de l'ordre de 10¹⁹ atomes/cm³. A titre d'exemple, la région 117 s'étend, à partir de la face supérieure de la couche 105, dans la couche 105 sur une profondeur comprise dans la plage allant de 1 µm à 5 µm.

A titre d'exemple, dans le dispositif de la figure 2, les deux métallisations de contact 113 formées en vis-à-vis des régions 109 du caisson 104 situé dans la partie gauche de la figure 2 sont par exemple reliées électriquement à la métallisation de contact 113 formée en vis-à-vis de la région 117 du caisson 104 situé dans la partie droite de la figure 2. En outre, ces métallisations sont reliées à une borne I/O 1 d'un circuit à protéger.

A titre d'exemple, dans le dispositif de la figure 2, les deux métallisations de contact 113 formées en vis-à-vis des régions 109 du caisson 104 situé dans la partie droite de la figure 2 sont par exemple reliées électriquement à la métallisation de contact 113 formée en vis-à-vis de la région 117 du caisson 104 situé dans la partie gauche de la figure 2. En outre, ces métallisations sont reliées à une borne I/O 2 d'un circuit à protéger.

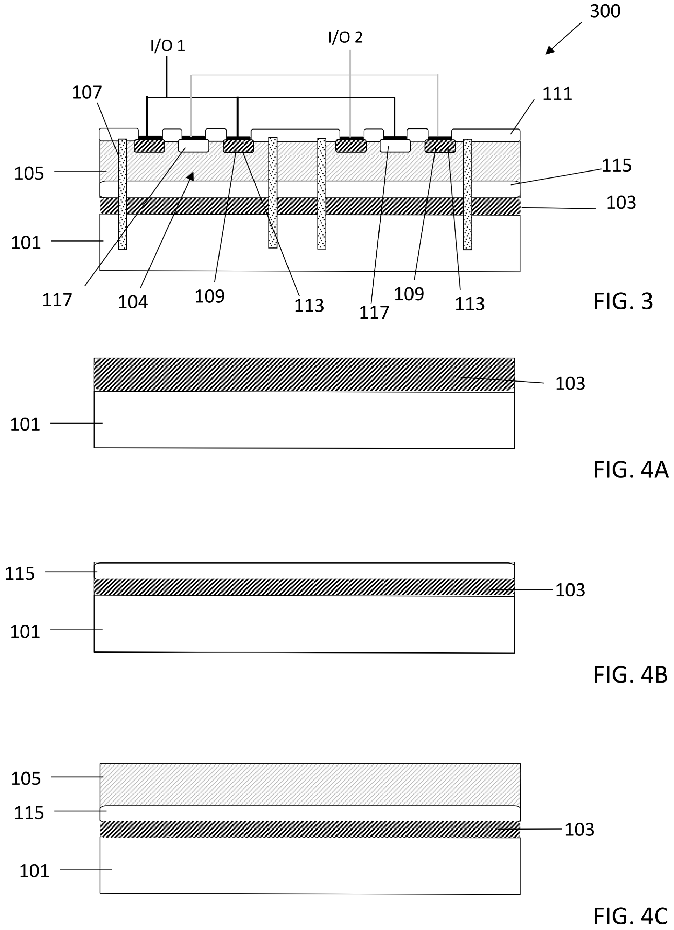

La figure 3 est une vue partielle et schématique d'un exemple d'un dispositif électronique de protection contre les décharges électrostatiques 300 selon un deuxième mode de réalisation.

Le dispositif 300 illustré en figure 3 est identique au dispositif 200 illustré en figure 2 à la différence près que, dans le dispositif 300, la couche semiconductrice 103 et la couche 115 s'étendent sur l'entièreté de la surface du dispositif 300. Plus précisément, dans cet exemple, les couches 103 et 115 s'étendent sur l'entièreté de la face supérieure du substrat 101. Dans cet exemple, les couches 103 et 115 s'étendent alors sous une pluralité de caissons 104.

Dans cet exemple, la couche 105 recouvre ainsi l'entièreté de la face supérieure de la couche 103 et est par exemple en contact avec la couche 103. Ainsi, la couche 105 n'est dans cet exemple pas en contact avec le substrat 101.

Un avantage des modes de réalisation décrits en figures 2 et 3 est qu'ils permettent de limiter les courants de conduction se formant autour des tranchées 107 sous la couche 103, du fait de l'ajout d'une jonction PN supplémentaire formée à l'interface entre les couches 115 et 103.

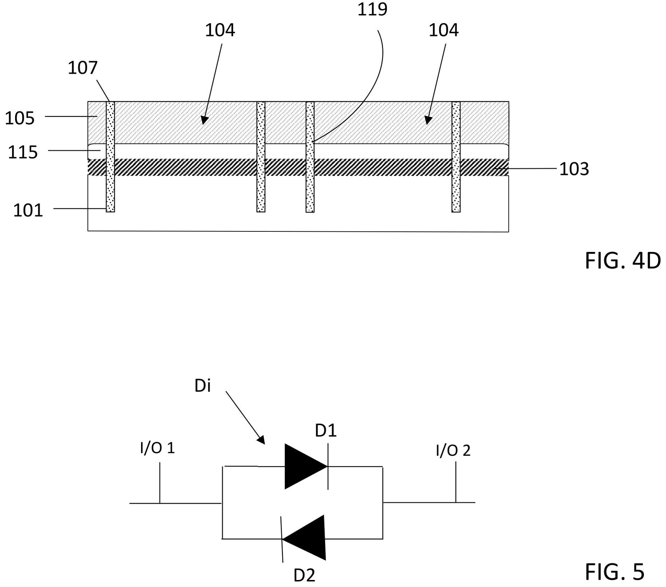

La figure 4A, la figure 4B, le figure 4C et la figure 4D sont des vues partielles et schématiques d'étapes successives d'un exemple d'un procédé de fabrication du dispositif électronique 300 illustré en figure 3.

La figure 4A illustre une structure comportant la couche 103 et le substrat 101.

Une telle structure peut être réalisée selon deux modes de mise en œuvre différents.

Dans un premier mode de mise en œuvre, une telle structure est réalisée à partir du substrat 101 sur lequel la couche 103 est formée. A titre d'exemple, la couche 103 est formée par épitaxie à partir de la face supérieure du substrat 101. La couche 103 est par exemple dopée in-situ lors de la croissance épitaxiale.

Dans un deuxième mode de mise en œuvre, une telle structure est formée par formation de la couche 103, par implantation ou diffusion d'éléments dopants, dans une partie supérieure du substrat 101. L'implantation d'éléments dopants est par exemple réalisée à partir de la face supérieure du substrat 101. La couche 103 est par exemple formée dans le substrat 101 de sorte que la couche 103 affleure la face supérieure du substrat 101. A titre d'exemple, lors de cette étape, l'implantation est réalisée sur l'entièreté de la surface du substrat semiconducteur 101.

La figure 4B illustre une structure obtenue à l'issue d'une étape de formation de la couche 115 sur la face supérieure de la structure illustrée en figure 4A.

Lors de cette étape, la couche 115 est par exemple formée par implantation ou diffusion d'éléments dopants, dans une partie supérieure de la couche 103. L'implantation d'éléments dopants est par exemple réalisée à partir de la face supérieure de la couche 103. La couche 115 est par exemple formée dans la couche 103 de sorte que la couche 115 affleure la face supérieure de la couche 103. A titre d'exemple, lors de cette étape, l'implantation est réalisée sur l'entièreté de la surface de la couche 103. Lors de cette étape, les éléments dopants formant la couche 115 sont par exemple implantés moins profondément que les éléments dopants formant la couche 103.

La figure 4C illustre une structure obtenue à l'issue d'une étape de formation de la couche 105 sur la face supérieure de la structure illustrée en figure 4B.

A titre d'exemple, la couche 105 est formée sur et en contact avec la couche 115.

La couche 105 est par exemple formée par épitaxie. La couche 105 est par exemple dopée in-situ lors de la croissance épitaxiale.

Les étapes d'épitaxie et de dopage permettant de former la couche 105 sont par exemple réalisées à partir de la face supérieure de la structure dans l'orientation de la figure 4B.

A titre d'exemple, à l'issue de cette étape, les couches 115 et 103 peuvent par exemple diffuser dans la couche 105. Une telle diffusion peut par exemple provoquer une diminution de l'épaisseur de la couche 105 au profit des couches 103 et 115.

La figure 4D illustre une structure obtenue à l'issue d'une étape de formation des tranchées d'isolation 107 dans la structure illustrée en figure 4C.

La formation des tranchées 107 comprend, par exemple, dans un premier temps, la formation d'ouvertures 119 dans les couches 105, 115 et 103. A titre d'exemple, les ouvertures traversent l'entièreté des couches 105, 115 et 103. A titre d'exemple, les ouvertures 119 sont par exemple, non traversantes. Les ouvertures 119 s'étendent par exemple à partir de la face supérieure de la couche 115 et débouchent dans le substrat 101.

La formation des tranchées 107 comprend, en outre, par exemple, dans un second temps, le remplissage des ouvertures 119 par un matériau isolant. Lors de l'étape de remplissage, le matériau isolant, déposé en excès, recouvre toute ou partie de la face supérieure de la couche 105. Cette étape est par exemple suivie par une étape de retrait du matériau isolant excédant recouvrant la face supérieure de la couche 105. L'étape de retrait est par exemple réalisée par polissage mécanique ou polissage mécanochimique.

A l'issue de cette étape, la structure subit par exemple une étape d'implantation des régions 109 et 117. A titre d'exemple, les régions 117 sont formées indépendamment des régions 109.

La structure subit en outre, par exemple une étape de formation de la couche isolante 111 sur la face supérieure de la couche 105. A titre d'exemple, à l'issue de son dépôt, la couche 111 est par exemple gravée de façon à dévoiler la face supérieure des régions 109 et 117.

En variante, les régions 109 et 117 sont formées avant la formation des tranchées 107. A titre d'exemple, le remplissage des tranchées 107 et la formation de la couche 111 correspond à une seule et même étape. Dans cette variante, le dépôt du matériau isolant de remplissage des ouvertures 119 est poursuivi alors que les ouvertures 119 sont remplies intégralement. Ainsi, ledit matériau se dépose sur la face supérieure de la couche 105. A la différence de ce qui a été décrit précédemment en relation avec la formation des tranchées 107 cette couche est par exemple conservée de façon à former la couche 111.

Encore, à l'issue de ces étapes, les métallisations de contact 113 sont par exemple formées sur et en contact avec les régions 109 et 117.

Les étapes décrites ci-avant correspondent à un exemple d'un procédé de fabrication du dispositif électronique 300 illustré en figure 3. Le procédé de fabrication du dispositif 200 illustré en figure 2 peut être très similaire à ce qui a été décrit ci-avant aux différences près que les couches 103 et 115 sont formées l'une et l'autre par implantation d'éléments dopants de façon localisée à travers un masque. A titre d'exemple, les deux étapes d'implantation d'éléments dopants permettant de former les couches 103 et 115 sont réalisées à travers un seul et même masque.

La figure 5 est un schéma électrique illustrant le circuit de protection contre les décharges électrostatiques du dispositif électronique 300 illustré en figure 3.

Le schéma électrique équivalant au dispositif électronique 300 illustré en figure 3 correspond à des diodes Di en direct pouvant être connectées en série en fonction du nombre de caissons 104.

A titre d'exemple, dans le caisson 104 situé dans la partie droite de la figure 2, la région 117 correspond à une anode d'une première diode D1 et les régions 109 correspondent à une cathode de la diode D1.

A titre d'exemple, dans le caisson 104 situé dans la partie gauche de la figure 2, la région 117 correspond à une anode d'une deuxième diode D2 et les régions 109 correspondent à une cathode de la diode D2.

Dans le schéma électrique de la figure 5, la cathode de la diode D1 est par exemple reliée à l'anode de la diode D2, ces deux bornes étant par exemple reliées à la borne I/O 2 d'un circuit à protéger. Dans le schéma électrique de la figure 5, la cathode de la diode D2 est par exemple reliée à l'anode de la diode D1, ces deux bornes étant par exemple reliées à la borne I/O 1 d'un circuit à protéger.

A titre d'exemple, il peut aussi être prévu que les diodes D1, D2 du dispositif électronique 300 soient des diodes polarisées en inverse. Dans cet exemple, le dispositif électronique 300 comprend dans chacun des caissons 104, une région enterrée sous et autour de la région 117. Une telle région enterrée est par exemple dopée du type P, par exemple moins fortement que la région 117.

Un avantage des présents modes de réalisation est qu'ils permettent de créer des caissons 104 isolés les uns des autres et ainsi de former des composants à conduction latérale dans les différents caissons.

De nombreuses applications sont susceptibles de tirer profit des avantages procurés par les dispositifs électroniques 200 et 300, ces dispositifs 200 et 300 pouvant ainsi être intégré dans divers types de composants.

À titre d'exemple, les dispositifs 200 et 300 peuvent être intégré dans un composant destiné à être utilisé dans l'électronique personnelle, par exemple dans le but d'augmenter un volume d'informations échangées par communication radiofréquence, dans des systèmes de communication 5G, ou plus généralement dans tout composant connecté. Le composant est par exemple un téléphone mobile, ou smartphone, ou fait partie d'un réseau de l'internet des objets. Le composant est par exemple connecté par 5G, par WiFi ou par communication large bande. Le composant comprend par exemple des interfaces à haut débit, par exemple avec un filtrage avancé et une protection contre les décharges électrostatiques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

De plus, on peut prévoir que les caissons accueillent d'autres types de composants, par exemple d'autres types de composants à deux pattes.

Enfin, la mise en œuvre pratique des modes de réalisation et variantes décrits est à la portée de la personne du métier à partir des indications fonctionnelles données ci-dessus.

## Revendications

1. Dispositif de protection contre les décharges électrostatiques (200 ; 300 ; 600) comprenant successivement :
- un substrat semiconducteur (101) dopé du type P ;
- une première couche semiconductrice (103) dopée du type N, sur et en contact avec une face supérieure du substrat semiconducteur (101);
- une deuxième couche semiconductrice (115) dopée d'atomes de bore, sur et en contact avec la première couche semiconductrice (103), la deuxième couche semiconductrice (115) ayant une concentration en atomes de bore supérieure ou égale à 10¹⁷ atomes/cm³ ; et
- une troisième couche semiconductrice (105) dopée du type N, sur une face supérieure de la deuxième couche semiconductrice (115), la première couche semiconductrice (103) étant plus fortement dopée que la troisième couche semiconductrice (105),
le dispositif comportant en outre des tranchées d'isolation (107) s'étendant à travers les première (103), deuxième (115) et troisième (105) couches semiconductrices et débouchant dans le substrat semiconducteur (101), définissant, dans la troisième couche semiconductrice (105), entre les tranchées d'isolation (107), au moins un caisson (104) .

2. Dispositif selon la revendication 1, dans lequel la deuxième couche semiconductrice (115) a une épaisseur comprise dans la plage allant de 3 µm à 5 µm.

3. Dispositif selon la revendication 1 ou 2, dans lequel les tranchées d'isolation (107) sont remplies d'un matériau isolant.

4. Dispositif selon l'une quelconque des revendications 1 à 3, dans lequel la deuxième couche semiconductrice (115) a une concentration en bore comprise dans la plage allant de 10¹⁷ atomes/cm³ à 10¹⁹ atomes/cm³.

5. Dispositif selon l'une quelconque des revendications 1 à 4, dans lequel la première couche semiconductrice (103) a une concentration en éléments dopants de type N comprise dans la plage allant de 10¹⁶ atomes/cm³ à 10¹⁸ atomes/cm³.

6. Dispositif selon l'une quelconque des revendications 1 à 5, dans lequel la première couche semiconductrice (103) a une épaisseur comprise dans la plage allant de 1 µm à 5 µm.

7. Dispositif selon l'une quelconque des revendications 1 à 6, dans lequel ledit au moins un caisson (104) a une largeur comprise dans la plage allant de 50 µm à 150 µm.

8. Dispositif selon l'une quelconque des revendications 1 à 7, dans lequel ledit au moins un caisson (104) comprend une diode (D1, D2, Di).

9. Dispositif selon l'une quelconque des revendications 1 à 7, dans lequel les tranchées d'isolation (107) définissent dans la troisième couche (105) plusieurs caissons (104) successifs comprenant chacun une diode, les diodes (D1, D2, Di) desdits caissons (104) successifs étant connectées en série.

10. Dispositif selon l'une quelconque des revendications 1 à 9, dans lequel les première (103) et deuxième (115) couches s'étendent chacune de façon continue sur sensiblement toute la surface du substrat et sont interrompues uniquement par les tranchées d'isolation (107).

11. Dispositif selon l'une quelconque des revendications 1 à 9, dans lequel les première (103) et deuxième (115) couches sont interrompues entre deux tranchées d'isolation (107) voisines.

12. Procédé de fabrication d'un dispositif de protection contre les décharges électrostatiques (200 ; 300 ; 600) comprenant les étapes suivantes successives :
a) former une première couche semiconductrice (103) dopée du type N, sur et en contact avec une face supérieure d'un substrat semiconducteur (101) dopé du type P;
b) former une deuxième couche semiconductrice (115) dopée d'atomes de bore, sur et en contact avec la première couche semiconductrice (103), la deuxième couche semiconductrice (115) ayant une concentration en atomes de bore supérieure ou égale à 10¹⁷ atomes/cm³ ;
c) former une troisième couche semiconductrice (105) dopée du type N, sur une face supérieure de la deuxième couche semiconductrice (115), la première couche semiconductrice (103) étant plus fortement dopée que la troisième couche semiconductrice (105) ; et
d) former deux tranchées d'isolation (107) s'étendant à travers les première (103), deuxième (115) et troisième (105) couches semiconductrices et débouchant dans le substrat semiconducteur (101), définissant, dans la troisième couche semiconductrice (105), entre les tranchées d'isolation (107), un caisson (104).

13. Procédé selon la revendication 12, dans lequel, la première couche (103) est formée par épitaxie à partir de la face supérieure du substrat (101) et la deuxième couche (115) est formée par implantation d'atomes de bore à partir de la face supérieure de la première couche (103).

14. Procédé selon la revendication 12, dans lequel, la première couche (103) et la deuxième couche (115) sont formées respectivement par implantation d'éléments dopants de type N et par implantation d'atomes de bore à partir de la face supérieure du substrat semiconducteur (101).
